# EUROPEAN PATENT APPLICATION

(11) **EP 3 605 628 A1**
(43) Date of publication of application: **05.02.2020**
(21) Application number: 17875066.7
(22) Date of filing: 14.11.2017
(51) Int. Cl.: H01L 51/00, C23C 14/04

(54) **MASK PLATE FOR EVAPORATION AND MANUFACTURING METHOD THEREFOR**

(30) Priority: 27.03.2017 CN 201710188795
(71) Applicant: BOE Technology Group Co., Ltd., Beijing 100015 (CN); Ordos Yuansheng Optoelectronics Co., Ltd., Ordos, Inner Mongolia 017020 (CN)
(72) Inventor: JI, Fengli, Beijing 100176 (CN); LIANG, Yinan, Beijing 100176 (CN)
(74) Representative: Klunker IP Patentanwälte PartG mbB
(86) International application number: PCT/CN2017/110766
(87) International publication number: WO 2018/176848

(57) **Abstract**

A mask and a manufacturing method thereof are disclosed. The mask includes a mask substrate (100); the mask substrate (100) includes a mask area (110); the mask area (110) includes an active area (120) and a dummy area (130) located at a periphery of the active area (120); a plurality of via holes (101) penetrating the mask substrate (100) is disposed in both of the active area (120) and the dummy area (130); the plurality of via holes (101) disposed in the dummy area (130) is filled with a blocking material (200). The mask fills a blocking material into a via hole disposed in a dummy area, which on one hand can prevent an evaporation material from being evaporated onto a base substrate to be evaporated, and on the other hand can help a mask area to achieve a tension balance and mitigate an issue of failed etching at an edge of an active area, so as to avoid the problem that an edge of an active display area as formed by evaporation using the mask involves a display abnormality, thereby improving a product yield.

## Description

The application claims priority of Chinese patent application No. 201710188795.7 filed on March 27, 2017, the entire disclosure of which is incorporated herein by reference as part of the present application.

### TECHNICAL FIELD

At least one embodiment of the present disclosure relates to an evaporation mask and a manufacturing method thereof.

### BACKGROUND

Organic light-emitting diode (OLED) refers to a phenomenon in which an organic semiconductor material and a light-emitting material are driven by an electric field so as to emit light through an injection and a recombination of carriers. The OLED emits light based on the principle that, a transparent electrode and a metal electrode are used as an anode and a cathode of a device, respectively. Driven by a certain voltage, electrons and holes are injected into an electron transmission layer and a hole transmission layer from the cathode and the anode, respectively. The electrons and holes are migrated to a light-emitting layer through the electron transmission layer and the hole transmission layer, respectively, and then encountered with each other in the light-emitting layer to generate excitons which excite light-emitting molecules. The light-emitting molecules emit visible light upon radiative relaxation. The emitted light can be observed from one side of the transparent electrode, and the metal electrode plays a role of reflecting layer at the same time.

As compared with conventional display technology, an active matrix/organic light-emitting diode (AMOLED) panel possesses the following advantages: AMOLED does not need liquid crystal but realizes self-illumination simply by means of an extremely thin, organic light-emitting layer, and hence can be made lighter and thinner; AMOLED can break through the constraint in the conventional arrangement manner of red, green and blue (RGB) pixels, and hence can achieve a pixel structure arranged in a PenTile layout so as to obtain an effect of high resolution; AMOLED realizes a display function by adopting the principle of self-illumination, and a black image can be displayed when pixels do not emit light so that the AMOLED not only can achieve a high contrast ratio but also can reduce a power consumption so as to obtain an effect of power saving. However, AMOLED, as an advanced display technology, has extremely strict requirement on the technical process, which involves difficulties in manufacturing a driving circuit and evaporating an organic light-emitting layer in the subsequent process.

### SUMMARY

At least one embodiment of the present disclosure provides an evaporation mask and a manufacturing method thereof. The evaporation mask fills a blocking material into a via hole disposed in a dummy area, which on one hand can prevent an evaporation material from being evaporated onto a base substrate to be evaporated, and on the other hand can help a mask area to achieve a tensioning balance and mitigate an issue of failed etching at an edge of an active area, so as to avoid the problem that an edge of an active display area as formed by evaporation using the mask involves a display abnormality, thereby improving a product yield.

At least one embodiment of the present disclosure provides an evaporation mask. The evaporation mask includes a mask substrate; the mask substrate includes a mask area; the mask area includes an active area and a dummy area located at a periphery of the active area; a plurality of via holes penetrating the mask substrate are disposed in both of the active area and the dummy area; the plurality of via holes disposed in the dummy area are filled with a blocking material.

For example, the blocking material includes at least one selected from the group consisting of polyimide, polycarbonate and polyacrylate.

For example, an overall shape of the mask area is a rectangular shape.

For example, the mask includes at least one active area, and a shape of each active area includes a circular shape, an ellipse shape, a polygon shape, a sector shape or an irregular shape.

For example, the active area is completely surrounded by the dummy area.

For example, the plurality of via holes disposed in the active area are arranged uniformly.

For example, a distribution density of the plurality of via holes disposed in the active area are substantially identical with a distribution density of the plurality of via holes disposed in the dummy area.

For example, a shape and a size of a cross section of each of the plurality of via holes disposed in the active area taken along a direction parallel to the mask substrate are substantially identical with a shape and a size of a cross section of each of the plurality of via holes disposed in the dummy area taken along the direction parallel to the mask substrate, respectively.

For example, an arrangement manner of the plurality of via holes disposed in the active area is substantially identical with an arrangement manner of the plurality of via holes disposed in the dummy area.

For example, a shape of a cross section of each of the plurality of via holes taken along a direction parallel to the mask is a polygon shape or a circular shape.

At least one embodiment of the present disclosure provides a manufacturing method of an evaporation mask. The manufacturing method of an evaporation mask includes: forming a plurality of via holes penetrating a mask substrate in a mask area of the mask substrate, the mask area including an active area and a dummy area located at a periphery of the active area, and both of the active area and the dummy area being provided with the via holes; filling a blocking material into the plurality of via holes in the dummy area.

For example, filling the blocking material into the plurality of via holes in the dummy area includes: coating the blocking material in the via holes located in the dummy area and coating the blocking material on a portion of the mask substrate located in the dummy area.

For example, the blocking material includes at least one selected from the group consisting of polyimide, polycarbonate and polyacrylate.

For example, an overall shape of the mask area as formed is a rectangular shape.

For example, the mask as formed includes at least one active area, and a shape of each active area includes a circular shape, an ellipse shape, a polygon shape, a sector shape or an irregular shape.

For example, the active area as formed is completely surrounded by the dummy area.

For example, a distribution density of the plurality of via holes formed in the active area is substantially identical with a distribution density of the plurality of via holes formed in the dummy area.

For example, a shape and a size of a cross section of each of the plurality of via holes formed in the active area taken along a direction parallel to the mask substrate are substantially identical with a shape and a size of a cross section of each of the plurality of via holes formed in the dummy area taken along the direction parallel to the mask substrate, respectively.

For example, an arrangement manner of the plurality of via holes formed in the active area is substantially identical with an arrangement manner of the plurality of via holes formed in the dummy area.

For example, forming a plurality of via holes penetrating a mask substrate includes: forming a plurality of via holes in the mask substrate by wet etching method.

### BRIEF DESCRIPTION OF THE DRAWINGS

Hereinafter, in order to clearly describe technical solutions of the embodiments in the present disclosure in a better way, the drawings of the embodiments will be briefly introduced. Obviously, the drawings to be described below merely relate to some embodiments of the present disclosure without any limitation to the present disclosure.
Fig. 1a is a schematic diagram of a fine metal mask for manufacturing a circular display panel;
Fig. 1b is a schematic diagram illustrating an effect of simulating a tension process of the fine metal mask illustrated in Fig. 1a by using software of finite element analysis (ANSYS);
Figs. 2a-2c are schematic diagrams illustrating an appearance of a mask substrate in the fine metal mask after etching;
Fig. 3a is a schematic diagram of a mask provided by an embodiment of the present disclosure;
Fig. 3b is a sectional view taken along a line AB of the mask illustrated in Fig. 3a;
Fig. 3c is a schematic diagram illustrating an effect of simulating a tensioning process of the fine metal mask illustrated in Fig. 3a by using software of finite element analysis (ANSYS), provided by an embodiment of the present disclosure;
Fig. 4 is a schematic diagram of a mask provided by another example provided by an embodiment of the present disclosure;
Fig. 5 is a schematic diagram of a mask provided by yet another example provided by an embodiment of the present disclosure; and
Fig. 6 is a schematic diagram of a manufacturing method of a mask provided by an embodiment of the present disclosure.

### DETAILED DESCRIPTION

Hereinafter, the technical solutions in the embodiments of the present disclosure will be clearly, completely described with reference to the drawings in the embodiments of the present disclosure, so that objectives, technical solutions and advantageous of the embodiments of the present disclosure will be more apparent. Obviously, the embodiments described are only a part of the embodiments, not all embodiments. Based on the described embodiments in the present disclosure, all other embodiments obtained by one skilled in the art without paying inventive labor are within the protection scope of the present disclosure.

Unless otherwise defined, all the technical and scientific terms used herein have the same meanings as commonly understood by one of ordinary skill in the art to which the present invention belongs. The terms "first," "second," etc., which are used in the present disclosure, are not intended to indicate any sequence, amount or importance, but distinguish various components. The phrases "comprise(s)" and "include(s)" etc., refer to that, an element or an object preceding this phrase encompasses element(s) or object(s) listed following this phrase, and equivalents thereof, without excluding the existence of other element(s) or object(s). "On," "under," "right," "left" and the like are only used to indicate relative position relationship, and when the position of the object which is described is changed, the relative position relationship may be changed accordingly.

A manufacturing process of an active matrix/organic light-emitting diode (AMOLED) panel includes evaporating an organic material onto a base substrate. Evaporating the organic material usually requires using a fine metal mask (FMM); that is, evaporating the organic material onto locations of red (R) pixel, green (G) pixel and blue (B) pixel on the base substrate, respectively, by utilizing various types of FMMs; R, G and B pixels in an active display area respectively correspond to locations of openings on the FMM.

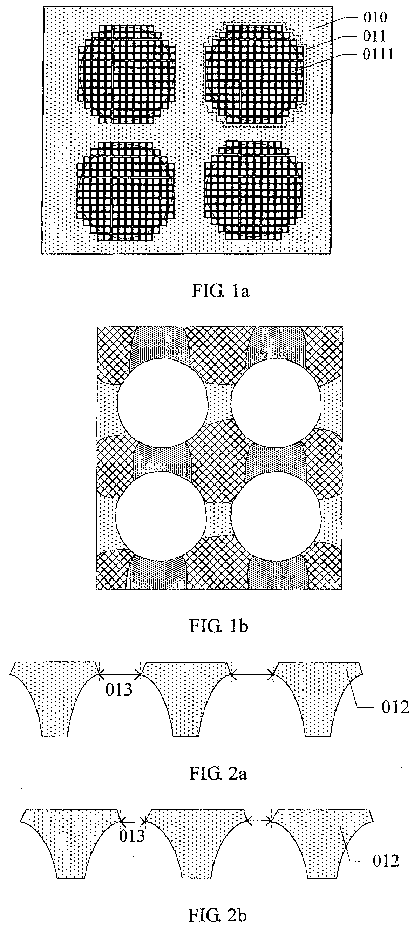

Fig. 1a is a schematic diagram of a FMM for manufacturing a circular display panel. As illustrated in Fig. 1a, the mask includes a mask substrate 010; the mask substrate 010 includes four mask pattern areas 011 disposed on the mask substrate 010; each of the mask pattern areas 011 is uniformly provided with a plurality of via holes 0111. These via holes 0111 correspond to an active display area of pixels to be evaporated, and are configured to evaporate light-emitting units on the display panel. Herein, an area indicated by a dashed-line frame in a zigzag polygon shape is just the mask pattern area 011. Fig. 1a is an illustrative, schematic diagram, the number of via holes in the mask pattern area applied in a practical process is relatively greater and a size of the via hole is small; as a result, the dashed-line box in a zigzag polygon shape is approximate to a circle; that is, a shape of the mask pattern area 011 is approximate to a circle (an approximate circle but not a standard circle). The mask pattern area 011 corresponds to a circular, active display area of a circular display panel to be formed; that is, a shape and a size of the mask pattern area 011 are identical with a shape and a size of the circular, active display area of the circular display panel to be formed, respectively.

Fig. 1b is a schematic diagram illustrating an effect of simulating a tension process of the FMM illustrated in Fig. 1a by using software of finite element analysis (ANSYS). As illustrated in Fig. 1b, four white circular areas correspond to the mask pattern areas 011 illustrated in Fig. 1a, and a periphery area of the circular area is denoted with different patterns, which indicates that a stress at an edge of the mask pattern area is not uniformly distributed. That is to say, the mask is likely to be deformed and generate a wrinkle because the edge of the mask pattern area is subjected to a nonuniform stress during the tension process. Therefore, after evaporating light-emitting units onto the base substrate by using the mask, when the display panel is lighted, a color abnormity may be occurred at the edge of the active display area.

Figs. 2a-2c are schematic diagrams illustrating an appearance of a mask substrate in a FMM after etching. Fig. 2a is a schematic diagram illustrating a normal, cross-sectional appearance of a mask substrate corresponding to a central location of a mask area, after etching. As illustrated in Fig. 2a, after etching, the mask substrate includes a metal bridge 012 and an opening part 013 located between adjacent metal bridges 012. Herein, the opening part 013 is just the via hole 0111 illustrated in Fig. 1a, and is configured to allow an evaporation material to pass there-through so that the evaporation material is evaporated onto locations of pixels on the base substrate. For example, a process of forming the opening part 013 includes: etching off part of the metal material on the mask substrate by an etching method using an etchant, with the metal material at the metal bridge 012 between adjacent opening parts 013 and the metal material around the mask pattern area 011 on the mask substrate 010 being remained without etching. That is to say, the metal bridge 012 and the area around the mask pattern area 011 that is not etched, together, constitute a blocking part for blocking the evaporation material.

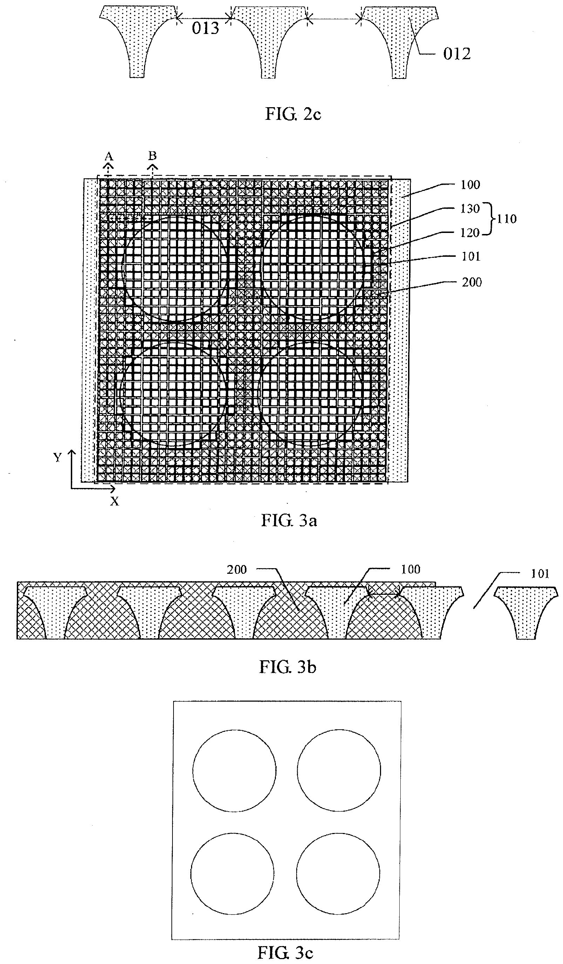

Because an etched appearance of a via hole formed at an edge around the mask pattern area is different from an etched appearance of a via hole formed at a center of the mask pattern area due to an uneven flow of an etchant during an etching process, generally two circumstances may be occurred at an interface between the mask pattern area and the metal material being not etched in an area around the mask pattern area on the mask substrate, i.e., at the edge around the mask pattern area, as illustrated in Fig. 2b and Fig.2c, respectively.

One of the circumstances is illustrated in Fig. 2b. The opening part 013 formed between adjacent metal bridges 012 at the edge around the mask pattern area has a relatively smaller size; i.e., during the etching process, less etchant is used at such location(s), thus the metal bridge 012 as formed has a relatively larger size, which results in the relatively smaller size of the opening part 013; as a result, an area of organic material evaporated onto the base substrate is smaller, resulting in the amount of the material evaporated onto the active display area being different from the edge to the center, leading to the issue that a brightness of the active display area is different from the edge to the center.

The other circumstance is illustrated in Fig. 2c. The opening part 013 formed between adjacent metal bridges 012 at the edge around the mask pattern area has a relatively greater size; i.e., during the etching process, more etchant is used at such location(s), thus the metal bridge 012 as formed has a relatively smaller size, which results in the relatively greater size of the opening part 013; therefore, an area of organic material evaporated onto the base substrate, and hence a shadow generated by the evaporation, are relatively larger, which leads to the issue that organic materials for evaporating different colors of pixels would be overlapped in the evaporation area, i.e., an issue of color blending may be occurred and affect a normal illumination at the edge of the active display area.

The two circumstances mentioned above both can result in an abnormal phenomenon at the edge of the active display area in the display panel.

Embodiments of the present disclosure provide an evaporation mask and a manufacturing method thereof. The evaporation mask includes a mask substrate; the mask substrate includes a mask area; the mask area includes an active area and a dummy area located at a periphery of the active area; a plurality of via holes are disposed in both of the active area and the dummy area; the plurality of via holes disposed in the dummy area are filled with a blocking material. The mask fills a blocking material into a via hole disposed in a dummy area, which on one hand can prevent an evaporation material from being evaporated onto a base substrate to be evaporated, and on the other hand can help a mask area to achieve a tension balance and mitigate an issue of failed etching at an edge of an active area, so as to avoid the problem that an edge of an active display area as formed by evaporation using the mask involves a display abnormality, thereby improving a product yield.

Hereinafter a mask and a manufacturing method thereof provided by embodiments of the present disclosure are described in conjunction with the drawings.

### First Embodiment

The present embodiment provides an evaporation mask. Fig. 3a is a schematic diagram of a mask provided by an embodiment of the present disclosure; and Fig. 3b is a sectional view taken along a line AB (parallel to X direction) of the mask illustrated in Fig. 3a. As illustrated in Fig. 3a and Fig. 3b, the mask includes a mask substrate 100; the mask substrate 100 includes a mask area 110; the mask area 110 includes an active area 120 and a dummy area 130 located at a periphery of the active area 120; a plurality of via holes 101 penetrating the mask substrate 100 are disposed in both of the active area 120 and the dummy area 130. It should be explained that, the mask area in the present embodiment includes a plurality of via holes and also includes a part of the mask substrate which is located between adjacent via holes and is not etched (i.e., the metal bridge illustrated in Fig. 2a).

For example, the mask area 110 is illustrated in Fig. 3a as an area surrounded by a rectangular dashed-line frame, and the area has a rectangular shape as a whole. In this example, the mask area 110 is a part of the mask substrate 100. However, the embodiments according to the present disclosure are not limited thereto, and the mask area can also occupy the entire mask substrate.

For example, a material of the mask substrate 100 is a metal material or a resin material. For example, the metal material can be any one or more selected from the group consisting of stainless steel, nickel (Ni), cobalt (Co), Ni alloy and Co alloy, without particularly limited in the embodiments of the present disclosure. For example, a tolerable temperature of the material of the mask substrate 100 is higher than or equal to 200°C so as to prevent a service life of the mask substrate from being reduced due to an excessively higher evaporation temperature during a high-temperature evaporation process.

For example, as illustrated in Fig. 3a, the active area 120 is an area indicated by a dashed-line frame in a zigzag polygon shape. It should be explained that, Fig. 3a is an illustrative, schematic diagram, the number of via holes in the mask area applied in a practical process is relatively greater and a size of the via hole is small; as a result, the dashed-line frame in a zigzag polygon shape is approximate to a circle; that is, a shape of the active area 120 is approximate to a circle (an approximate circle but not a standard circle). The active area 120 corresponds to a circular, active display area of a circular display panel to be formed; that is, a shape and a size of the active area 120 are identical with a shape and a size of the circular, active display area of the circular display panel to be formed, respectively.

For example, as illustrated in Fig. 3a, the plurality of via holes 101 in the active area 120 each have a white color, which indicates that the via hole in this area allows an evaporation material to pass there-through so as to be evaporated onto an area on a base substrate to be evaporated corresponding to the via hole 101, e.g., a base substrate of an organic light-emitting diode (OLED) display panel. The active area 120 on the mask of the present embodiment is just the mask pattern area (i.e., the mask pattern area 011 in Fig. 1a) of a conventional mask, and a size and a shape of the active area 120 are identical with that of an active display area on a display panel, respectively. The present embodiment is described with reference to the case of evaporating a light-emitting layer onto a base substrate of an OLED by way of example, but is not limited thereto. The base substrate can be replaced by other types of substrates and the light-emitting layer can be replaced by other types of layers.

For example, the mask includes at least one active area 120, and Fig. 3a describes the case where the mask includes four active areas 120, by way of example. However, the present embodiment is not limited thereto. For example, the number of the active area on the mask can be configured as one, two or more.

For example, as illustrated in Fig. 3a, the dummy area 130 is an area located at a periphery of the active area 120, and the plurality of via holes 101 disposed in the dummy area 130 are filled with a blocking material 200 so as to prevent an evaporation material from being evaporated onto a location of the base substrate which doesn't need the evaporation material, that is, a non-evaporation area. It should be explained that, the phrase "the plurality of via holes 101 disposed in the dummy area 130 are filled with a blocking material 200" may encompass the case (i.e., as illustrated in Fig. 3b) that the plurality of via holes 101 located in the dummy area 130 and the portions being not etched (i.e., the metal bridge 013 illustrated in Fig. 2a) on the mask substrate between adjacent via holes 101 are all provided with the blocking material 200. The embodiment includes such case but is not limited thereto. For example, it may further encompass the case that the blocking material 200 is filled only in the plurality of via holes 101 located in the dummy area 130. The dummy area 130 on the mask substrate 100 in the present embodiment corresponds to an area being not etched around the mask pattern area on a conventional mask substrate (as illustrated in Fig. 1a).

For example, as illustrated in Fig. 3a, a shadow covering the via hole 101 indicates the blocking material 200 filled in the via hole, while an area in which the via hole is covered with the shadow in this figure indicates the dummy area 130. The dummy area 130 in Fig. 3a is an area only covered with the shadow in the rectangular dashed-line box. For example, the dummy area 130 is all the areas in the mask area 110 except the active area 120.

For example, the blocking material 200 is a material with excellent elasticity, including any one of or a combination of polyimide, polycarbonate and polyacrylate. That is to say, the blocking material 200 filled in the plurality of via holes 101 disposed in the dummy area 130 is an elastic material, so as to prevent the mask from warping during tension process and hence to facilitate the mask area 110 to achieve a tension balance, thereby mitigating the issue of color abnormality occurred at the edge of the active display area on the display panel as obtained by using the mask. For example, the blocking material includes a material with a relatively smaller coefficient of thermal expansion, so as to prevent the mask from deforming due to a thermal expansion during evaporation.

For example, as illustrated in Fig. 3a, an overall shape of the mask area 110 on the mask is a rectangular shape; that is to say, an area constituted by the active area 120 and the dummy area 130, together, has a rectangular shape. Herein, the active area 120 and the dummy area 130 in the mask area 110 may be considered as two areas which are complemented with each other; that is to say, the active area 120 is an evaporation area, and an evaporation source evaporates the evaporation material onto a location corresponding to a pixel unit on a base substrate to be evaporated, through the via hole 101 in the active area 120; the dummy area 130 is a blocking area to prevent the evaporation material from being evaporated onto a location of the base substrate which doesn't need the evaporation material. The mask area in the present embodiment, as a whole, adopts a rectangular shape. Unlike the circular shape of the display panel to be formed, the rectangular shape can prevent the mask from generating a wrinkle due to uneven stress subjected by the mask during the tension process, which facilitates controlling a tension wrinkle, thereby mitigating the issue of color abnormality occurred at the edge of the active display area on the display panel to be formed.

For example, the active area 120 illustrated in Fig. 3a is completely surrounded by the dummy area 130; that is, at least one circle of via holes 101 in the dummy area 130 are distributed around the outside of the via hole 101 at the edge of the active area 120. By disposing the via hole 101 in the dummy area 130, an area in which the via hole 101 at the edge of the active area 120 is etched to have an abnormal appearance due to nonuniform etchant is moved to a location where the via hole 101 at the edge of the dummy area 130 is located; that is to say, the via hole 101 at the edge of the active area 120 in the present embodiment is no longer located at an edge position of the via hole 101 in the mask area 110. The present embodiment includes such case but is not limited thereto. For example, the active area can also be partly surrounded by the dummy area; that is, one half of the active area can be surrounded by the dummy area, and the like. The mask provided by the present embodiment can effectively avoid an abnormal etching of the via hole to be occurred at the edge of the active area, thereby mitigating the issue of color abnormality occurred at the edge of the active display area on the display panel to be formed and improving the product yield.

For example, as illustrated in Fig. 3a, the plurality of via holes 101 disposed in the active area 120 are arranged uniformly, without limiting the present embodiment thereto. It should be explained that, the plurality of via holes 101 in the active area 120 correspond to the location of the pixel units on the display panel to be formed. As a result, a size and an arrangement manner of the plurality of via holes 101 in the active area 120 are determined according to a size and an arrangement manner of the pixel units on the display panel to be formed.

For example, the plurality of via holes 101 disposed in the dummy area 130 are arranged uniformly, without limiting the present embodiment thereto. For example, the plurality of via holes 101 disposed in the dummy area 130 can also be arranged nonuniformly.

For example, as illustrated in Fig. 3a, a distribution density of the plurality of via holes 101 disposed in the active area 120 is substantially identical with a distribution density of the plurality of via holes 101 disposed in the dummy area 130; that is, the plurality of via holes 101 disposed in the active area 120 and the plurality of via holes 101 disposed in the dummy area 130 both are arranged in an array. The present embodiment includes such case but is not limited thereto. For example, the distribution density of the plurality of via holes 101 disposed in the active area 120 can be different from the distribution density of the plurality of via holes 101 disposed in the dummy area 130. The present embodiment adopts the solution in which the distribution density of the plurality of via holes disposed in the active area is substantially identical with the distribution density of the plurality of via holes disposed in the dummy area. In this way, it can effectively help the mask to maintain a stress uniformity during the tension process, and help the active area to achieve a stress balance so as to prevent from a wrinkle generated in the active area which may result in an issue of color abnormity occurred at the edge of the active display area on the display panel to be formed. Herein, "substantially identical" encompasses the case of "totally identical" and the case of "almost identical". It should be explained that, in the description as below, the expression "identical" includes both of "absolutely identical" and "approximately identical".

For example, as illustrated in Fig. 3a, an arrangement manner of the plurality of via holes 101 disposed in the active area 120 is identical with an arrangement manner of the plurality of via holes 101 disposed in the dummy area 130. The present embodiment includes such case but is not limited thereto. For example, the arrangement manner of the plurality of via holes 101 disposed in the active area 120 can be different from the arrangement manner of the plurality of via holes 101 disposed in the dummy area 130. The present embodiment adopts the solution in which the arrangement manner of the plurality of via holes disposed in the active area is identical with the arrangement manner of the plurality of via holes disposed in the dummy area, which can effectively facilitate maintaining a stress uniformity of the mask during the tension process.

For example, a shape of a cross section of each of the plurality of via holes 101 taken along a direction parallel to the mask substrate 100 is a polygon shape. Fig. 3a describes the case of rectangular shape by way of example, without limiting the present embodiment thereto. The cross section may have other polygon shapes.

For example, as illustrated in Fig. 3a, a shape and a size of a cross section of each of the plurality of via holes 101 disposed in the active area 120 taken along a direction parallel to the mask substrate 100 are identical with a shape and a size of a cross section of each of the plurality of via holes 101 disposed in the dummy area 130 taken along the direction parallel to the mask substrate 100, respectively. The present embodiment includes such case but is not limited thereto. For example, the cross sections of the plurality of via holes disposed in the active area taken along the direction parallel to the mask substrate all have the same shape and the same size; while the shape and the size of the cross section of each of the plurality of via holes disposed in the active area taken along the direction parallel to the mask substrate are different from the shape and the size of the cross section of each of the plurality of via holes disposed in the dummy area taken along the direction parallel to the mask substrate. The present embodiment adopts the solution in which the the shape and the size of the cross section of each of the plurality of via holes disposed in the active area taken along the direction parallel to the mask substrate are identical with the shape and the size of the cross section of each of the plurality of via holes disposed in the dummy area taken along the direction parallel to the mask substrate respectively, which can effectively facilitate maintaining a stress uniformity of the mask substrate during the tension process so as to avoid a wrinkle occurred at the edge of the active area.

For example, not all the cross sections of the plurality of via holes disposed in the active area taken along the direction parallel to the mask substrate have the same size; that is, not all the pixel units on the display panel to be formed corresponding to the plurality of via holes disposed in the active area have the same size; in other words, the active are of the mask can be configured to form pixel structures arranged in a PenTile layout by evaporation.

Fig. 3c is a schematic diagram illustrating an effect of simulating a tensioning process of the FMM illustrated in Fig. 3a by using software of finite element analysis (ANSYS). As illustrated in Fig. 3c, four white circular areas correspond to the circular areas in the active area 120 illustrated in Fig. 3a. Unlike what is illustrated in Fig. 1b, periphery areas of the circular areas illustrated in Fig. 3c have the same color, i.e., white color, and the color of the periphery area is the same with that of the circular area, i.e.,, white color; then the case illustrated in Fig. 3c indicates that, a stress is uniformly distributed at the edge of the active area, and a stress in the entire mask area is uniformly distributed; as a result, the mask provided by the present embodiment maintains a stress uniformity during the tension process, thereby mitigating the issue of color abnormality occurred at the edge of the active display area on the display panel to be formed and improving the product yield.

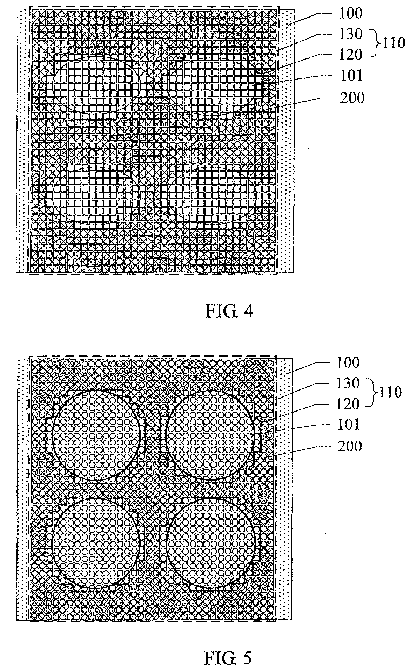

Fig. 4 is a schematic diagram of a mask provided by another example of the present embodiment. As illustrated in Fig. 4, each active area 120 has an ellipse shape (approximate ellipse but not a standard ellipse). The present embodiment includes such case but is not limited thereto. For example, the shape of the active area can also be polygon, sector, irregular graph or regular graph such as rectangle.

Fig. 5 is a schematic diagram of a mask provided by yet another example of the present embodiment. As illustrated in Fig. 5, the shape of the cross section of each of the plurality of via holes 101 taken along the direction parallel to the mask can be circle, without limiting the present embodiment thereto.

### Second Embodiment

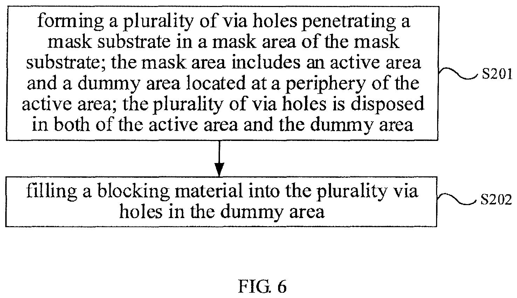

The present embodiment provides a manufacturing method of an evaporation mask. Specific steps in the manufacturing method of the mask are illustrated in Fig. 6, including:
Step S201, forming a plurality of via holes penetrating a mask substrate in a mask area of the mask substrate; the mask area includes an active area and a dummy area located at a periphery of the active area; the plurality of via holes is disposed in both of the active area and the dummy area.

For example, a material of the mask substrate is a metal material or a resin material. For example, the metal material can be any one or more selected from the group consisting of stainless steel, nickel (Ni), cobalt (Co), Ni alloy and Co alloy, without limiting the present embodiment thereto.

For example, forming a plurality of via holes penetrating a mask substrate on the mask substrate includes: forming a plurality of via holes in the mask substrate by using wet etching method. For example, an etching method using an etchant can be utilized to etch off the metal material or resin material on the mask substrate, so as to form the plurality of via holes as required in the present embodiment. The present embodiment is not limited to wet etching method. For example, other methods such as dry etching can also be adopted to form the plurality of via holes.

For example, the mask area includes an active area and a dummy area located at a periphery area of the active area. For example, the active area as formed is completely surrounded by the dummy area; that is, at least one circle of via holes in the dummy area are distributed around the outside of the via holes at the edge of the active area. By disposing the via holes in the dummy area, an area in which the via hole at the edge of the active area is etched to have an abnormal appearance due to nonuniform etchant is moved to a location where the via hole at the edge of the dummy area is located; that is to say, the via hole at the edge of the active area in the present embodiment is no longer located at an edge position of the via hole in the mask area. The present embodiment is not limited to the case in which the active area is completely surrounded by the dummy area. For example, the active area can also be partly surrounded by the dummy area; that is, one half of the active area can be surrounded by the dummy area. The mask provided by the present embodiment can effectively avoid an abnormal etching of the via hole to be occurred at the edge of the active area, thereby mitigating the issue of color abnormality occurred at the edge of the active display area on the display panel to be formed and improving the product yield.

For example, the active area included in the mask area on the mask is an evaporation area; when evaporating the base substrate to be evaporated by using an evaporation source, the evaporation source can evaporate the evaporation material onto a location corresponding to the pixel unit on the base substrate to be evaporated, through the via holes in the active area. The active area on the mask of the present embodiment is just the mask pattern area (i.e., the mask pattern area 011 in Fig. 1a) of a conventional mask, and a size and a shape of the active area are identical with that of an active display area on a display panel, respectively. The present embodiment is described with reference to the case of evaporating a light-emitting layer onto a base substrate of an OLED, by way of example, without limiting the present embodiment thereto. The base substrate can be replaced by other types of substrates and the light-emitting layer can be replaced by other types of layers.

For example, a shape of the active area as formed can include a circular shape, an ellipse shape, a polygon shape, a sector shape or an irregular shape. The present embodiment includes such case but is not limited thereto. For example, the shape of the active area can also be a regular shape such as rectangle. The present embodiment is described with reference to the case where the display panel to be formed has a circular shape. For example, the active area on the mask corresponds to a circular, active display area on a circular display panel to be formed; that is, a shape and a size of the active area are identical with that of the circular, active display area on the circular display panel to be formed.

For example, the plurality of via holes formed in the active area are uniformly distributed, without limiting the present embodiment thereto. It should be explained that, the plurality of via holes in the active area correspond to the locations of pixel units on the display panel to be formed. As a result, a size and an arrangement manner of the plurality of via holes in the active area are determined according to a size and an arrangement manner of the pixel units on the display panel to be formed.

For example, the plurality of via holes formed in the dummy area is arranged uniformly, without limiting the present embodiment thereto. For example, the plurality of via holes disposed in the dummy area can also be arranged nonuniformly.

For example, a distribution density of the plurality of via holes formed in the active area is identical with a distribution density of the plurality of via holes formed in the dummy area. That is, the plurality of via holes formed in the active area and the plurality of via holes formed in the dummy area both are arranged in an array. The present embodiment includes such case but is not limited thereto. For example, the distribution density of the plurality of via holes formed in the active area can be different from the distribution density of the plurality of via holes formed in the dummy area. The present embodiment adopts the solution in which the distribution density of the plurality of via holes formed in the active area is identical with the distribution density of the plurality of via holes formed in the dummy area. In this way, it can effectively help the mask to maintain a stress uniformity during the tension process, and help the active area to achieve a stress balance so as to prevent from a wrinkle generated in the active area which may result in an issue of color abnormity occurred at the edge of the active display area on the display panel to be formed.

For example, an arrangement manner of the plurality of via holes formed in the active area is identical with an arrangement manner of the plurality of via holes formed in the dummy area. The present embodiment includes such case but is not limited thereto. For example, the arrangement manner of the plurality of via holes formed in the active area can be different from the arrangement manner of the plurality of via holes formed in the dummy area. The present embodiment adopts the solution in which the arrangement manner of the plurality of via holes formed in the active area is identical with the arrangement manner of the plurality of via holes formed in the dummy area, so as to effectively facilitate maintaining a stress uniformity of the mask during the tension process.

For example, a shape of a cross section of each of the plurality of via holes as formed taken along a direction parallel to the mask substrate is a polygon shape or a circular shape, without particularly limited in the present embodiment.

For example, a shape and a size of a cross section of each of the plurality of via holes formed in the active area taken along a direction parallel to the mask substrate are identical with a shape and a size of a cross section of each of the plurality of via holes formed in the dummy area taken along the direction parallel to the mask substrate, respectively. The present embodiment includes such case but is not limited thereto. For example, the cross sections of the plurality of via holes formed in the active area taken along the direction parallel to the mask substrate have the same shape and the same size; while the shape and the size of the cross section of each of the plurality of via holes formed in the active area taken along the direction parallel to the mask substrate are different from the shape and the size of the cross section of each of the plurality of via holes formed in the dummy area taken along the direction parallel to the mask substrate. The present embodiment adopts the solution in which the the shape and the size of the cross section of each of the plurality of via holes formed in the active area taken along the direction parallel to the mask substrate are identical with the shape and the size of the cross section of each of the plurality of via holes formed in the dummy area taken along the direction parallel to the mask substrate, respectively, so as to effectively facilitate maintaining a stress uniformity of the mask during the tensioning process and to avoid a wrinkle generated in the active area.

For example, not all the cross sections of the plurality of via holes formed in the active area taken along the direction parallel to the mask substrate are identical with each other; that is, not all the pixel units on the display panel to be formed corresponding to the plurality of via holes in the active area have the same size; in other words, the active area of the mask can be configured to form pixel structures arranged in a PenTile layout by evaporation.

For example, the mask as formed includes at least one active area, that is, the mask as formed can include one or more active area. The number of the active area as formed in the mask is not particularly limited in the present embodiment.

For example, the mask area as formed has a rectangle shape, as a whole. That is to say, an area constituted by the active area and the dummy area, together, has a rectangular shape. Herein, the active area and the dummy area in the mask area may be considered as two areas which are complemented with each other. The mask area in the present embodiment, as a whole, adopts a rectangular shape. Unlike the circular area of the display panel to be formed, the rectangular shape can prevent the mask from generating a wrinkle due to uneven stress subjected by the mask during the tensioning process, which facilitates controlling a tension wrinkle, thereby mitigating the issue of color abnormality occurred at the edge of the active display area on the display panel to be formed and improving the product yield.

Step S202, filling a blocking material into the plurality via holes in the dummy area.

For example, filling a blocking material into the plurality via holes in the dummy area can prevent the evaporation material from being evaporated to a location on a base substrate which doesn't need the evaporation material; that is, the dummy area is a nonevaporation area. It should be explained that, the phrase "filling a blocking material into the plurality via holes in the dummy area" may encompass the case (i.e., as illustrated in Fig. 3b) that the plurality of via holes located in the dummy area and the portions being not etched on the mask substrate between adjacent via holes are all provided with the blocking material. The embodiment includes such case but is not limited thereto. For example, it may further encompass the case where the blocking material is filled only in the plurality of via holes located in the dummy area. The dummy area on the mask substrate in the present embodiment corresponds to an area being not etched around the mask pattern area on a conventional mask substrate (as illustrated in Fig. 1a).

For example, the blocking material is a material with excellent elasticity, including any one of polyimide, polycarbonate and polyacrylate or a combination thereof. That is to say, the blocking material filled in the plurality of via holes disposed in the dummy area is an elastic material so as to prevent the mask from warping during the tension process and hence to facilitate the mask area to achieve a tension balance, thereby mitigating the issue of color abnormality occurred at the edge of the active display area on the display panel to be formed and effectively improving the product yield.

The following statements should be noted:
(1) Unless otherwise defined, in the embodiment(s) and accompanying drawings of the present disclosure, the same reference numeral indicates the same meaning.
(2) The accompanying drawings of the embodiment(s) of the present disclosure involve only the structure(s) in connection with the embodiment(s) of the present disclosure, and other structure(s) can be referred to common design(s).
(3) For the purpose of clarity, in the accompanying drawings for illustrating the embodiment(s) of the present disclosure, a layer or an area may be enlarged. It should be understood that, in the case in which a component such as a layer, film, area, substrate or the like is referred to be "on" or "under" another component, it may be directly on or under the another component or yet another component is interposed therebetween.

The foregoing are merely specific embodiments of the invention, but not limitative to the protection scope of the invention. Within the technical scope disclosed by the present disclosure, any alternations or replacements which can be readily envisaged by one skilled in the art shall be within the protection scope of the present disclosure. Therefore, the protection scope of the invention shall be defined by the accompanying claims.

## Claims

1. An evaporation mask, comprising:
a mask substrate, comprising a mask area which comprises an active area and a dummy area located at a periphery of the active area, a plurality of via holes penetrating the mask substrate being disposed in both of the active area and the dummy area,
the plurality of via holes disposed in the dummy area being filled with a blocking material.

2. The evaporation mask according to claim 1, wherein the blocking material comprises at least one selected from the group consisting of polyimide, polycarbonate and polyacrylate.

3. The evaporation mask according to claim 1 or 2, wherein an overall shape of the mask area is a rectangular shape.

4. The evaporation mask according to any one of claims 1-3, comprising at least one active area, wherein a shape of each active area comprises a circular shape, an ellipse shape, a polygon shape, a sector shape or an irregular shape.

5. The evaporation mask according to any one of claims 1-4, wherein the active area is completely surrounded by the dummy area.

6. The evaporation mask according to any one of claims 1-5, wherein the plurality of via holes disposed in the active area are arranged uniformly.

7. The evaporation mask according to any one of claims 1-6, wherein a distribution density of the plurality of via holes disposed in the active area is substantially identical with a distribution density of the plurality of via holes disposed in the dummy area.

8. The evaporation mask according to any one of claims 1-7, wherein a shape and a size of a cross section of each of the plurality of via holes disposed in the active area taken along a direction parallel to the mask substrate are substantially identical with a shape and a size of a cross section of each of the plurality of via holes disposed in the dummy area taken along the direction parallel to the mask substrate, respectively.

9. The evaporation mask according to any one of claims 1-8, wherein an arrangement manner of the plurality of via holes disposed in the active area is substantially identical with an arrangement manner of the plurality of via holes disposed in the dummy area.

10. The evaporation mask according to any one of claims 1-9, wherein a shape of a cross section of each of the plurality of via holes taken along a direction parallel to the mask is a polygon shape or a circular shape.

11. A manufacturing method of an evaporation mask, comprising:
forming a plurality of via holes penetrating a mask substrate in a mask area of the mask substrate, the mask area comprising an active area and a dummy area located at a periphery of the active area, both of the active area and the dummy area being provided with the via holes; and
filling a blocking material into the plurality of via holes in the dummy area.

12. The manufacturing method according to claim 11, wherein forming the plurality of via holes penetrating the mask substrate comprises:
forming the plurality of via holes in the mask substrate by wet etching method.

13. The manufacturing method according to claim 11 or 12, wherein filling the blocking material into the plurality of via holes in the dummy area comprises:
coating the blocking material in the via holes located in the dummy area and coating the blocking material on a portion of the mask substrate located in the dummy area.

14. The manufacturing method according to any one of claims 11-13, wherein the blocking material comprises at least one selected from the group consisting of polyimide, polycarbonate and polyacrylate.

15. The manufacturing method according to any one of claims 11-14, wherein an overall shape of the mask area as formed is a rectangular shape.

16. The manufacturing method according to any one of claims 11-15, wherein the mask as formed comprises at least one active area, and a shape of each active area comprises a circular shape, an ellipse shape, a polygon shape, a sector shape or an irregular shape.

17. The manufacturing method according to any one of claims 11-16, wherein the active area as formed is completely surrounded by the dummy area.

18. The manufacturing method according to any one of claims 11-17, wherein a distribution density of the plurality of via holes formed in the active area is substantially identical with a distribution density of the plurality of via holes formed in the dummy area.

19. The manufacturing method according to any one of claims 11-18, wherein a shape and a size of a cross section of each of the plurality of via holes formed in the active area taken along a direction parallel to the mask substrate are substantially identical with a shape and a size of a cross section of each of the plurality of via holes formed in the dummy area taken along the direction parallel to the mask substrate, respectively.

20. The manufacturing method according to any one of claims 11-19, wherein an arrangement manner of the plurality of via holes formed in the active area is substantially identical with an arrangement manner of the plurality of via holes formed in the dummy area.
